Europäisches Patentamt

European Patent Office

Office européen des brevets

(11) Veröffentlichungsnummer: **0 448 610 B1**

# EUROPÄISCHE PATENTSCHRIFT

(45) Veröffentlichungstag der Patentschrift: **29.06.94**

(21) Anmeldenummer: **90900794.0**

(22) Anmeldetag: **15.12.89**

(86) Internationale Anmeldenummer:
**PCT/EP89/01545**

(87) Internationale Veröffentlichungsnummer:
**WO 90/07229 (28.06.90 90/15)**

(51) Int. Cl.5: **H02P  6/02**, H02P 7/62,
H02P 8/00

(54) **VERFAHREN UND ANORDNUNG ZUR ANSTEUERUNG ELEKTROMECHANISCHER WANDLER.**

(30) Priorität: **15.12.88 CH 4643/88**
**18.12.88 CH 4644/88**
**02.03.89 CH 763/89**
**21.04.89 CH 1523/89**
**15.09.89 DE 3930898**

(43) Veröffentlichungstag der Anmeldung:
**02.10.91 Patentblatt  91/40**

(45) Bekanntmachung des Hinweises auf die
Patenterteilung:
**29.06.94 Patentblatt  94/26**

(84) Benannte Vertragsstaaten:
**DE GB IT**

(56) Entgegenhaltungen:
**EP-A- 180 083**
**DE-A- 2 737 372**
**DE-A- 2 834 740**
**DE-A- 3 009 393**

(73) Patentinhaber: **PAPST-MOTOREN GMBH & CO.
KG
Karl-Maier-Strasse 1
D-78112 St Georgen(DE)**

(72) Erfinder: **AMRHEIN, Wolfgang
Moos
CH-8848 Trachslau(CH)**

(74) Vertreter: **Westphal, Klaus, Dipl.-Ing. et al
Patentanwälte,
Dipl.-Ing. Klaus Westphal,
Dr.rer.nat. Otto Buchner,
Dr.rer.nat.Bernd Mussgnug,
Dr.-Ing.Peter
Neunert,
Waldstrasse 33
D-78048 Villingen-Schwenningen (DE)**

**Beschreibung**

Die Erfindung betrifft ein Verfahren zur Ansteuerung elektromechanischer Wandler zwecks Erzeugung eines vorgegebenen Kraft- bzw. Drehmomentverlaufs, insbesondere zur Verminderung winkelabhängiger Drehmomentschwankungen in Elektromotoren, bei dem in einem Funktionsspeicher zeit- oder positionsabhängige (weg- bzw. drehwinkelabhängige) Datensätze gespeichert werden, die abhängig vom im Betrieb zurückgelegten Weg bzw. Drehwinkel oder zeitgesteuert abgerufen und in einer arithmetischen Schaltungseinheit mit einer Eingangsgröße zu Augenblickswerten verknüpft werden, und bei dem abhängig von den Augenblickswerten Spannungen oder Ströme mit entsprechender zeit- oder positionsabhängiger Kurvenform in die elektrischen Anschlüsse des Wandlers eingeprägt werden. Darüber hinaus ist eine Anordnung zur Durchführung eines solchen Verfahrens Gegenstand der vorliegenden Erfindung.

Eine wichtige Eigenschaft z. B. eines Elektromotors ist seine Rundlaufgüte (bzw. der gleichförmige Kraftverlauf eines elektromechanischen Wandlers). Sie beeinflußt sowohl die Genauigkeit als auch die Stabilität eines Antriebssystems. Um die störenden Drehmomentpulsationen bei Motoren unterdrücken zu können, bedarf es zunächst einer Lokalisierung der Ursache. Vier Faktoren sind im wesentlichen für die Drehmomentschwankungen verantwortlich:

Bereits bei stromlosem Anker können bei Motoren mit permanentmagnetischer Erregung oder auch bei Motoren mit Eisenteilen hoher Remanenzinduktion, permanentmagnetische Drehmomentschwankungen entstehen, ausgelöst durch die Wechselwirkung zwischen den permanentmagnetischen Materialien und den Wicklungsnuten oder anderen ferromagnetischen Teilen. Eine Drehung des Rotors führt zu Schwankungen der Gesamtenergie des magnetischen Kreises und somit zu winkelabhängigen Drehmomenten mit wechselnd stabilen und instabilen Extremwerten.

Im Gegensatz dazu resultieren die elektromagnetischen Drehmomentschwankungen aus der Wechselwirkung zwischen dem Ankerstrombelag und dem Magnetfeld. Die elektromagnetischen Schwankungen sind ein Resultat der speziellen Magnetfeldverteilung im Luftspalt, der Wicklungsanordnung, sowie der Ankerstromkurvenform in Abhängigkeit vom Rotorwinkel.

Eine winkelabhängige Änderung der Motorinduktivität, wie sie beispielsweise bei ungleichförmigem Luftspalt, bei partieller Eisensättigung, bei einer bezüglich des magnetischen Leitwertes ungleichförmigen Materialverteilung und anderen Effekten auf-tritt, führt im Verein mit den Ankerströmen zu reluktanten Drehmomentschwankungen.

Drehmomentpulsationen im Motor können auch mechanische Ursachen haben. Die mechanischen Drehmomentschwankungen, wie wir sie der Einfachheit im folgenden nennen wollen, werden beispielsweise ausgelöst durch unsymmetrische Verspannungen der Motorwelle, wie Achsenversatz bei Kupplungen, exzentrische Lagersitze etc. Sie können auch von der mit dem Motor (oder allgemein Wandler) gekuppelten Last herrühren.

In der Regel treten alle vier genannten Drehmomentschwankungsarten gemeinsam im Elektromotor auf, jedoch meist mit unterschiedlicher Größenordnung der einzelnen Komponenten. Es gibt Fälle, in denen einzelne Komponenten gegenüber den anderen vernachlässigbar sind.

Es sind bereits Anstrengungen unternommen worden, die Rundlaufgüte von Elektromotoren durch konstruktive Maßnahmen zu verbessern.

Der Anteil der permanentmagnetischen Drehmomentschwankungen läßt sich beispielsweise durch die Verwendung einer eisenlosen Wicklung kombiniert mit einem ringförmigen Eisenrückschluß eliminieren (Beispiel: Glockenankermotoren). Bereits eine starke Reduktion wird erreicht durch die Schrägung des Eisenblechpaketes, z.B. um eine Nutteilung, sowie durch eine geeignete Gestaltung der Magnetform und der Nut-, Zahn- oder der Polschuhgeometrie. Antriebsmotoren, die für stationäre Drehzahlen ausgelegt sind, werden häufig mit einer zusätzlichen Schwungmasse ausgerüstet (z.B. Plattenspieler).

Die elektromagnetische Polfühligkeit läßt sich konstruktiv beispielsweise durch eine dem Luftspaltfeld und der Stromkurve angepaßte Wahl der Wicklungsauslegung günstig beeinflussen, und somit auch durch eine Schrägung der Nutteilung.

Die reluktanten Drehmomentschwankungen lassen sich unter anderem durch Verwendung von rotationssymmetrisch angeordneten weich- und hartmagnetischen Werkstoffen stark reduzieren.

Diese bekannten konstruktiven Maßnahmen zur Verbesserung der Rundlaufgüte bzw. entsprechende Maßnahmen zum Erreichen eines gleichförmigen Kraftverlaufes eines allgemeinen, elektromechanischen Wandlers (z.B. Linearmotor, Lautsprecher o.dgl.) stoßen jedoch an Grenzen, ohne eine völlige Gleichförmigkeit zu erreichen. Darüber hinaus bedeuten solche konstruktiven Maßnahmen häufig eine Verteuerung der Konstruktion, zusätzliche Toleranzprobleme oder eine Verschlechterung der Daten solcher Elektromotoren oder Wandler.

Eine andere Möglichkeit, den Gleichlauf zu verbessern, ist die elektrische Kompensation der Drehmomentpulsationen. Im einfachsten Fall sorgt eine selbsttätige Regeleinrichtung für verbesserten Gleichlauf, Hochlauf oder Positionierung. Die an den Regler gestellten Forderungen nach adaptiven Regelparametern, Schnelligkeit und Stabilität lassen sich jedoch mit dieser Methode nicht immer zufriedenstellend erfüllen. Es bietet sich deshalb an, den Regler von der Ausregelung der Pendelmomente zu entlasten und die für konstantes Drehmoment erforderlichen Stromoberschwingungen nach einer Kennlinie zu erzeugen, die aus den Motordaten im voraus ermittelt wurden.

Eine bei bürstenlosen DC-Motoren häufig angewandte Methode ist die Variation des Verhältnisses von Ein- und Ausschaltbereich der Rechteckansteuerung. Durch eine entsprechende Wahl des Einschaltbereiches der verschiedenen Phasen wird eine verbesserte Gleichlaufcharakteristik erzielt (Literaturstellen 1 bis 3).

Eine universelle und noch besser angepaßte Ansteuerung erhält man durch Superposition definierter Stromharmonischen (Literaturstellen 4 bis 9). Die erforderlichen Summenstromkurven können hierbei stark von einer Sinus- oder Rechteckform abweichen. Ohne äußere Eingriffe am Motor läßt sich hiermit rein elektronisch die Gleichlaufgüte erheblich verbessern. Dem Motorentwickler eröffnet sich nun die Freiheit, den Antrieb nach anderen Gesichtspunkten zu optimieren (z.B. günstigere Fertigungsmethoden). Nicht verschwiegen werden soll jedoch der hierfür nötige höhere Aufwand an Steuer- und Leistungselektronik. Die jüngsten Fortschritte in der Mikroelektronik und bei den Leistungstransistoren erleichtern heute die Realisierung solcher hochwertigen Servoantriebssysteme erheblich.

Bisherige Arbeiten zu dem letztgenannten Themenkreis beschränken sich lediglich auf die elektronische Kompensation der elektromagnetischen Drehmomentschwankungen. Dies ist in der Regel für einen Elektroantrieb nur ausreichend, wenn das erzeugte Nutzdrehmoment sehr viel größer ist als die übrigen winkelabhängigen Störpulsationen. Im allgemeinen ist diese Voraussetzung nicht gegeben. Erwünscht ist hier vielmehr ein Antrieb, der über den gesamten Drehmomentbereich winkelunabhängig konstantes Moment liefert, d.h. eine gleichzeitige Reduktion permanentmagnetischer, elektromagnetischer, reluktanter und mechanischer Drehmomentschwankungen oder einer Auswahl aus diesen, falls eine oder mehrere Komponenten vernachlässigbar sind.

Außerdem ist es aus der EP-A-180 083 bereits bekannt, ein definiertes winkelabhängiges Drehmoment durch entsprechende Ansteuerung mit Strömen besonderer Kurvenform zu erzeugen. Bei dieser bekannten Maßnahme werden jedoch nur reluktante Drehmomentschwankungen reduziert, und zwar auch nicht sehr weitgehend, da die verwendeten Ansteuerkurven symmetrisch trapezförmig oder sinusförmig mit abgeflachtem Maximalbereich ausgebildet sind.

Der vorliegenden Erfindung liegt die Aufgabe zugrunde, ein Verfahren sowie eine Anordnung zur Ansteuerung elektromechanischer Wandler zwecks Erzeugung eines vorgegebenen Kraft- bzw. Drehmomentverlaufs vorzuschlagen, bei dem alle, zumindest die wichtigsten und am stärksten in Erscheinung tretenden, sich auf den Kraft- bzw. Drehmomentverlauf auswirkenden Komponenten sowie gegebenenfalls auch andere Störgrößen in anderen Richtungen berücksichtigt werden, um insbesondere eine gute Rundlaufgüte bei Elektromotoren zu erzielen, wobei hierzu keine konstruktiven Maßnahmen am Motor vorgenommen werden müssen.

Die Aufgabe wird durch die Merkmale der Ansprüche 1,3,4 und 15 gelöst.

Diese Aufgabe wird bei einem Verfahren der eingangs genannten Art dadurch gelöst, daß in dem Funktionsspeicher mehrere verschiedene, aus dem Kraft- bzw. Drehmomentverlauf des Wandlers und gegebenenfalls einer angeschlossenen Last ermittelte, verschiedene Einflüsse berücksichtigende Datensätze, insbesondere in Form von Tabellen, Vorschriften, Gleichungen oder Funktionen, gespeichert werden, daß diese Datensätze positionsabhängig (z.B. bei einem selbstgesteuerten Synchronmotor) oder zeitabhängig (z.B. bei einem Schrittmotor) aus dem Funktionsspeicher abgerufen und getrennt nach den Einflüssen satzweise mit mindestens je einer Eingangsgröße verknüpft werden, und daß diese so erhaltenen Verknüpfungsergebnisse zu den positions- bzw. zeitabhängigen Augenblickswerten zusammengesetzt werden.

Das erfindungsgemäße Verfahren, sowie eine entsprechende Anordnung, haben den Vorteil, daß sich ein einfacherer Aufbau des Wandlers bei geringeren Toleranzanforderungen ergibt, und daß sich im Falle der Verminderung der positionsabhängigen Kraft- und Drehmomentschwankungen bei Elektromotoren Geräuschminderungen ergeben und besondere Schwungmassen in den Antrieben entfallen können.

Je nach der Motorbauart ist es zur Vereinfachung der Ansteuerung möglich, nur einige der Einflüsse auf den Kraft- bzw. Drehmomentverlauf zu berücksichtigen. Bei einem elektromagnetischen Wandler werden jedoch vorzugsweise einer der Einflüsse a), c) oder d), oder wenigstens zwei der nachfolgenden Einflüsse berücksichtigt:

a) elektromagnetische Einflüsse,
b) reluktante Einflüsse,

3

c) permanentmagnetische und mechanische Einflüsse,

d) mechanische Einflüsse (im Wandler und gegebenenfalls auch der angeschlossenen Last).

Haben einer oder mehrere der Einflüsse bei der entsprechenden Wandlerbauart nur einen geringen Einfluß auf den Kraft- bzw. Drehmomentverlauf, so können diese dann unberücksichtigt bleiben.

Um auch in anderen Richtungen als die Nutzkraft oder das Nutzdrehmoment auftretende Störkräfte kompensieren zu können, hier sind bei Rotationsmotoren besonders die radialen und die axialen Störkräfte zu erwähnen, kann dies durch Einprägung von zusätzlihen, speziellen Spannungs- oder Stromkomponenten berücksichtigt werden.

Die den Kraft- bzw. Drehmomentverlauf des Wandlers und gegebenenfalls der Last berücksichtigenden Datensätze können entweder aus den gegebenen Konstruktions- und Materialdaten berechnet werden, oder sie werden aus an einem Muster gemessenen Parametern und/oder Kennlinien indirekt berechnet. Im ersten Fall ist weder ein Prüfstand erforderlich noch sind sonstige Messungen erforderlich.

Es ist jedoch auch möglich, die den Kraft- bzw. Drehmomentverlauf des Wandlers und gegebenenfalls der Last berücksichtigenden Datensätze durch Meßläufe zur Optimierung zwecks Erreichens des beliebig vorgegebenen Kraft- bzw. Drehmomentverlaufs eines Musters auf einem Meß- und Prüfstand zu ermitteln. Für diese Lösung ist zwar ein Prüfstand erforderlich, sie ermöglicht jedoch unabhängig von Herstellungs- und Materialtoleranzen einen individuellen Feinabgleich, was durch Berechnungen nicht möglich ist. Für diese Lösung gibt es zwei Verfahren, und zwar das direkte (Messen, Ermittlung der Datensätze, Betrieb des Wandlers mit den Datensätzen) sowie das iterative Verfahren, bei dem den Schritten des direkten Verfahrens sich die erneute Messung, die Korrektur der Datensätze und der Betrieb des Wandlers mit den korrigierten Werten anschließt, wobei diese anschließenden Schritte beliebig oft wiederholt werden.

Eine zweckmäßige Anordnung zur Durchführung des erfindungsgemäßen Verfahrens ist gekennzeichnet durch einen Funktionsspeicher mit je einem Speicherabschnitt pro zu berücksichtigenden Einfluß zur Speicherung des zugeordneten Datensatzes, eine arithmetische Schaltungseinheit zum Verknüpfen von aus den Speicherabschnitten ausgelesenen Datensätzen mit je mindestens einer Eingangsgröße und zum Zusammenfassen der Verknüpfungsergebnisse zu Augenblickswerten, einen dem elektromechanischen Wandler zugeordneten Positions- oder Zeitgeber zur Steuerung des positions- oder zeitabhängigen Auslesens der Daten im Funktionsspeicher, und einen Leistungssteller zum Einprägen von Spannungen oder Strömen in die elektrischen Anschlüsse des Wandlers entsprechend den Augenblickswerten.

Handelt es sich um einen mehrphasigen Wandler, z.B. einen mehrphasigen Elektromotor, so können für jede der einzelnen Phasen Datensätze abgespeichert und hieraus entsprechende Augenblickswerte abgeleitet werden, wobei für jede der einzelnen Phasen entsprechende Funktionsspeicher, arithmetische Schaltungseinheiten und Leistungssteller bzw. entsprechende Abschnitte, vorgesehen sind, oder diese im Zeitmultiplex betrieben werden. In einem solchen Fall können Unsymmetrien und andere Abweichungen zwischen den einzelnen Phasen des Wandlers berücksichtigt werden. Eine einfachere Lösung besteht jedoch darin, wenn für alle Phasen gemeinsame Datensätze abgespeichert sind und entweder für die einzelnen Phasen diese Datensätze phasenversetzt ausgelesen und durch die arithmetischen Schaltungseinheiten zu Augenblickswerten für die einzelnen Phasen verknüpft werden, oder daß aus diesen gemeinsamen Datensätzen gemeinsame Augenblickswerte abgeleitet werden und eine Phasenschiebereinheit vorgesehen ist, die aus den gemeinsamen Augenblickswerten die um die entsprechenden Phasenwinkel verschobenen Augenblickswerte für alle Phasen ableitet. Diese letztere Lösung erfordert einen geringeren Aufwand, kann jedoch Unsymmetrien zwischen den einzelnen Phasen nicht berücksichtigen wie die erste Lösung.

Weitere vorteilhafte Ausgestaltungen der Erfindung sind weiteren Unteransprüchen zu entnehmen.

Die Erfindung wird nachfolgend anhand von Ausführungsbeispielen unter Bezug auf die beigefügten Zeichnungen näher erläutert.

Es zeigen:

Fig. 1        das Ersatzschaltbild eines permanentmagneterregten Synchronmotors;

Fig. 2        ein Flußdiagramm zur Ermittlung der Phasenströme für den Elektromotor zwecks Reduktion der elektromagnetischen Drehmomentschwankungen;

Fig. 3        eine Darstellung der induzierten Spannung in einer Phase eines vierphasigen Motors in normierter Form;

Fig. 4        das Schaltbild einer Einrichtung für die direkte Messung des Stillstandsmomentes eines Mustermotors;

Fig. 5        das Schaltbild für eine indirekte Messung des Stillstandsmomentes eines Mustermotors;

Fig. 6        ein Flußdiagramm zur iterativen Bestimmung der Phasenströme für die Reduktion der permanentmagnetischen und mechanischen Drehmomentschwankungen eines Motors, aufgeteilt in drei Teile (Fig. 6a, 6b und 6c);

Fig. 7        eine Darstellung der nach dem Flußdiagramm der Fig. 6 iterativ ermittelten Stromkurve für eine Phase in normierter Form;

Fig. 8      eine Darstellung der permanentmagnetischen und mechanischen Drehmomentschwankungen des Prüfmotors im Stillstand vor einer elektronischen Korrektur (ohne Reibungsmoment);

Fig. 9      eine Darstellung der Drehmomentschwankungen ähnlich wie in Fig. 8, jedoch nach der elektronischen Korrektur;

Fig. 10      das Blockschaltbild in vereinfachter Darstellung einer Anordnung zur Ansteuerung eines elektromechanischen Wandlers in Form eines Elektromotors; und

Fig. 11a-c      Darstellungen der Phasenstromkurven des Prüfmotors im stromlosen Zustand, bei einem Strom von 0,1 A bzw. bei einem Strom von 0,5 A.

Unter dem Begriff "elektromechanischer Wandler" sind beliebige Wandler zu verstehen, die aus einem elektrischen Strom oder einer Spannung eine mechanische Wirkung hervorrufen oder umgekehrt, z.B. elektromagnetische Wandler, piezoelektrische Wandler, Elektretwandler, Thermowandler. Von besonderer Bedeutung sind rotierende Elektromotoren und Generatoren (ideale Bremse) sowie Linearmotoren, aber auch Lautsprecherantriebssysteme, Relais, Stellglieder und Zugmagneten.

Da auch das mechanische Verhalten von mit den Wandlern gekuppelten Lasten (z.B. rotierende und allgemeine Hebel- und sonstige Getriebe) den Kraftoder Drehmomentverlauf beeinflussen, können auch diese in Kombination mit den Wandlern berücksichtigt werden.

Auch können sich Kraftschwankungen in anderen Richtungen als die Nutzkraft oder das Nutzmoment auswirken und werden bei Bedarf berücksichtigt. Dies gilt z.B. für axiale oder radiale Störkräfte in rotierenden Wandlern, die sich nicht direkt, sondern indirekt auf das Betriebsverhalten auswirken oder zusätzlichen Verschleiß oder Geräusche verursachen.

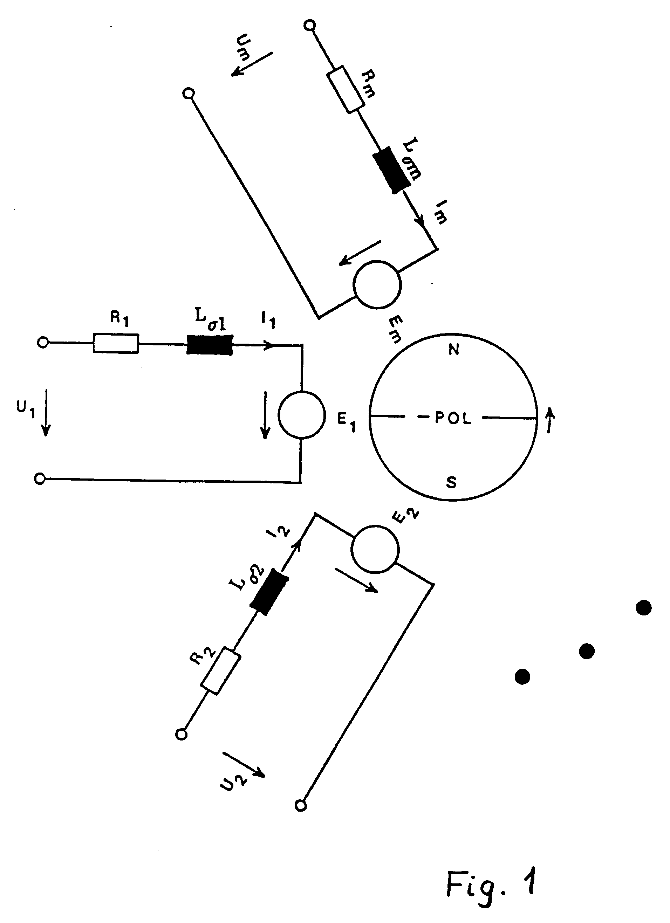

Zunächst sollen anhand des elektrischen Ersatzschaltbildes nach Fig. 1 das Drehmoment bzw. die Drehmomentschwankungen aus der Motorenergiebilanz hergeleitet werden. Die Drehmomentgleichung für das Ersatzschaltbild nach Fig. 1 lautet wie folgt:

$$T(\delta) = \sum_{k=1}^{m} \left[ \frac{E_k(\delta)}{\omega} I_k(\delta) + \frac{1}{2} \sum_{i=1}^{m} \frac{dL_{ki}(\delta)}{d\delta} I_i(\delta) I_k(\delta) \right] + T_r(\delta) \qquad (1-15)$$

$$\underbrace{\phantom{xxxxxxx}}_{\substack{\text{1. Term} \\ \text{(Einfluß a)}}} \qquad \underbrace{\phantom{xxxxxxxxxxxx}}_{\substack{\text{2. Term} \\ \text{(Einfluß b)}}} \qquad \underbrace{\phantom{xxxxxxx}}_{\substack{\text{3. Term} \\ \text{(Einflüsse c + d)}}}$$

Hierbei sind

T      das resultierende Drehmoment

$T_r$      die Summe aus den permanentmagnetischen und den mechanischen Momentenschwankungen,

E      die induzierte Phasenspannung,

I      der Phasenstrom

L      die Motorinduktivität,

ω      die Rotorwinkelgeschwindigkeit,

δ      der Rotorwinkel,

m      Phasenzahl und

i,k      Laufvariable für die Motorphasen.

Wie man aus der Drehmomentgleichung erkennen kann, trägt die Stromänderungsgeschwindigkeit nicht zur Drehmomentbildung bei. Das Gesamtdrehmoment besteht aus vier Anteilen:

a) der elektromagnetischen Komponente,

b) der reluktanten Komponente,

c) der permanentmagnetischen Komponente, und

d) der mechanischen Komponente.

Der erste Term der Drehmomentgleichung beinhaltet den elektromagnetischen Drehmomentanteil. Er wird bestimmt durch die Wechselwirkung zwischen den magnetischen Spulenflüssen und den zugehörigen Ankerströmen. Der elektromagnetische Anteil besteht aus einem konstanten Nutzmoment, sowie einem überlagerten Pulsationsmoment.

Der zweite Term aus der Drehmomentgleichung beschreibt das Reluktanzmoment. Eine winkelabhängige Änderung der Motorinduktivität, wie sie beispielsweise bei ungleichförmigem Luftspalt auftritt, führt im Verein mit den Ankerströmen zu einem resultierenden Moment, welches abhängig von der Speisung und Konstruktion aus einem konstanten Nutzmoment und Pulsationsmoment besteht.

Der dritte Term aus der Drehmomentgleichung zeigt den permanentmagnetischen und den mechanischen Anteil. Dieser erzeugt aufgrund der Wechselwirkung zwischen Ankernuten und Permanentmagneten Rastmomente und somit störende Pulsationen. Die Größe dieser vier Komponenten wird durch das Prinzip und die Motorkonstruktion beeinflußt.

Isoliert man den elektromagnetischen Drehmomentanteil aus der Drehmomenthauptgleichung (1-15) von den übrigen Komponenten, so ergibt sich:

$$T_{el} = \frac{1}{\omega} \sum_{k=1}^{m} E_k(\delta)\, I_k(\delta) ; \qquad\qquad ( \quad 2 \, -1)$$

Zur gewünschten Bedingung

$$T_{el} = \text{const.} \qquad ( 2 -2)$$

sollen nun die Beziehungen für die erforderlichen Phasenströme hergeleitet werden.

Das Gleichungssystem (2 -1...2) ist in seiner bisherigen Form unterbestimmt. Eine zweckmäßige Zusatzbedingung kann aufgestellt werden. Hier wurde die Forderung nach minimalen Wicklungsverlusten gewählt:

$$P_v = \sum_{k=1}^{m} \left[ R_k\, I_k(\delta)^2 \right] = \text{minimal} ; \qquad\qquad ( \quad 2 \, -3)$$

Zur Lösung dieser Extremwertaufgabe mit m Variablen und der Nebenbedingung (Gleichung 2 -1 und -2) ermittelt man die notwendigen Bedingungen mit Hilfe des Lagrangeschen Multiplikators $\lambda$ aus folgendem Ansatz:

$$\frac{\partial P_v}{\partial I_k} - \lambda \frac{\partial T_{el}}{\partial I_k} = 0 ; \qquad\qquad ( \quad 2 \, -4)$$

Dieser Ansatz gilt für eine unabhängige Steuerung der Phasenströme. Eine weitere Zusatzbedingung, zum Beispiel die Forderung

$$\sum_{k=1}^{m} I_k = 0 ,$$

erfordert die Einführung eines weiteren Lagrangeschen Multiplikators. Durch diese Zusatzbedingung kann jedoch die Verlustleistung ansteigen.

Hieraus gewinnt man

$$2R_k I_k(\delta) - \lambda \tfrac{1}{\omega} E_k(\delta) = 0; \qquad ( 2 -5)$$

und

$$I_k(\delta) = \lambda \frac{E_k(\delta)}{2\,\omega\,R_k}; \qquad\qquad (\quad 2\ -6)$$

Gleichung (-6) eingesetzt in die Drehmomentgleichung (-1) führt zu

$$T_{el} = \lambda \frac{1}{2\omega^2} \sum_{k=1}^{m} \frac{E_k(\delta)^2}{R_k}; \qquad\qquad (\quad .2\ -7)$$

Der Lagrangesche Multiplikator ist somit bestimmt durch

$$\lambda = \frac{2\,\omega^2\,T_{el}}{\displaystyle\sum_{k=1}^{m} \frac{E_k(\delta)^2}{R_k}}; \qquad\qquad (\quad .2\ -8)$$

Aus den Beziehungen (-6) und (-8) erhält man die gewünschten Stromgleichungen der Phasen $k = 1...m$ zur Reduktion der elektromagnetischen Drehmomentschwankungen:

$$I_k(\delta) = \frac{T_{el}\,\omega\,E_k(\delta)}{R_k \displaystyle\sum_{\kappa=1}^{m} \frac{E_\kappa(\delta)^2}{R_\kappa}}; \qquad\qquad (\quad 2\ .-9)$$

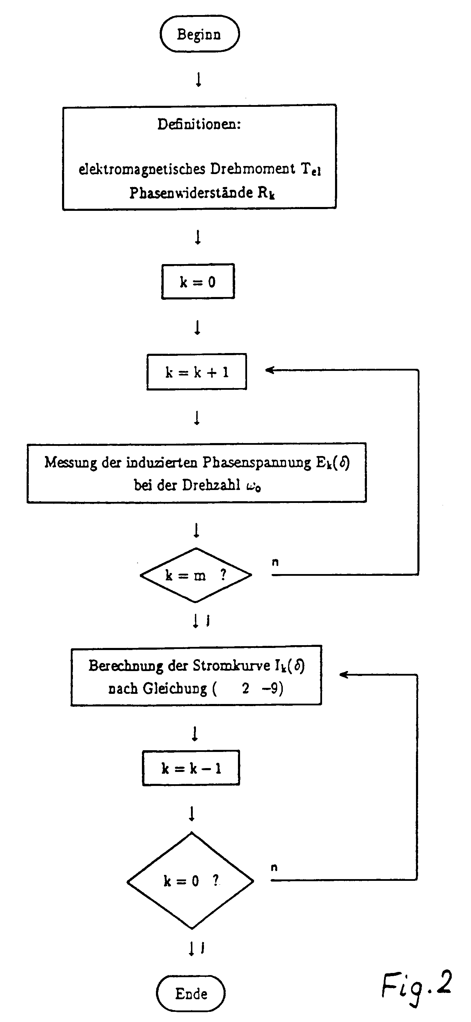

Diese Phasenströme können in einem rechnergesteuerten Motorprüfstand (der später noch erläutert wird) nach dem Flußdiagramm nach Fig. 2 ermittelt werden. Für das Beispiel eines 2-poligen elektronisch kommutierten Motors mit vier Phasen sind die Stromkurvenformen zur Reduktion der elektromagnetischen Drehmomentschwankung ermittelt worden. Es wurde hierbei ein Motor als Beispiel ausgewählt, der sowohl sehr hohe elektromagnetische als auch permanentmagnetische Drehmomentpulsationen aufweist.

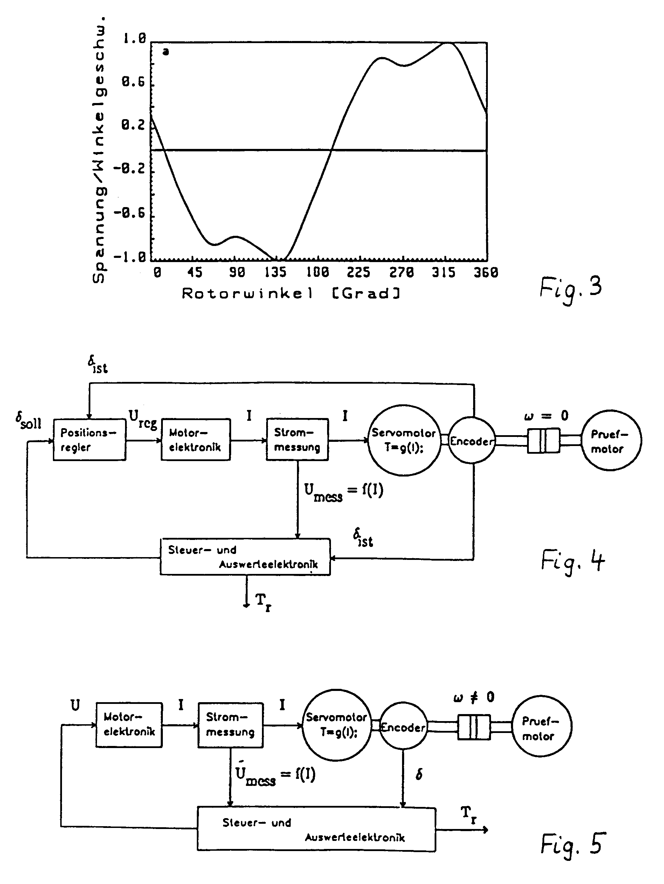

Die Phasenspannungscharakteristik für eine Phase des Motors ist in Fig. 3 gezeigt. Die induzierten Spannungen wurden bei sehr hoher Drehzahl (5000 U/min) aufgenommen, so daß Störeinflüsse aufgrund von Drehzahlschwankungen vernachlässigbar sind. Falls diese Messungen bei niedrigeren Drehzahlen vorgenommen werden müssen, so wäre eine zusätzliche Schwungmasse erforderlich. Wird dieser Motor mit den nach dem Flußdiagramm nach Fig. 2 bestimmten Phasenstromkurven gespeist, so ergibt sich ein sehr gleichmäßiger Drehmomentverlauf ohne Schwankungen. Eventuelle Reststörungen können durch eine Messung entdekt werden und durch entprechend angepaßte Stromkurven in einem zweiten Schritt oder in zusätzlichen nachfolgenden Schritten eliminiert werden.

Neben dem vorstehend beschriebenen Verfahren zur Berechnung der Motorphasenströme ist es auch möglich, ein Verfahren anzuwenden, das auf der harmonischen Analyse beruht. Zur Kompensation der einzelnen Drehmomentoberschwingungen wird die Ordnungszahl der Stromharmonischen so bestimmt, daß diese mit der größten Spannungsharmonischen (Grundharmonische) zusammenwirken. Die dabei auftretenden Störmomente, die aus der Wechselwirkung der berechneten Stromharmonischen mit Spannungskomponenten entstehen, deren Ordnungszahl von der Grundharmonischen abweicht, werden berechnet und durch einen iterativen Korrekturprozeß schrittweise eliminiert.

Ein Vergleich der beiden Berechnungsmethoden zeigt, daß praktisch die gleichen Ergebnisse erzielt werden, wobei die schnellere und in der Lösungsstruktur einfachere Methode das direkte, zuerst beschriebene Verfahren ist.

Das permanentmagnetische Rastmoment aus der Drehmomentgleichung (Gl. 1-15) ist eine Funktion des Rotorwinkels $\delta$.

$$T_r = T_r(\delta); \qquad (3-1)$$

Im Gegensatz zu den elektromagnetischen Drehmomentpulsationen ist dieser Teil stromunabhängig. Die Bestimmung des Momentenverlaufes kann über eine Feldberechnung oder direkt über eine Messung erfolgen. Der Weg über die (numerischen) Feldberechnungen führt aus den bereits erwähnten Gründen teilweise zu sehr unsicheren Ergebnissen. Hinzu kommt die Unkenntnis der Vorgeschichte der Rotormagnete, die infolge zu hoher thermischer Belastung oder zu großer Ankerrückwirkung bereits partiell teilentmagnetisiert sein können. Die Auswirkung dieser Effekte werden bei einer Drehmomentmessung direkt miterfaßt. Zwei Verfahren bieten sich zur Drehmomentmessung an:

| Messverfahren / Auswahl- kriterien | direkt $(\omega = 0)$ | indirekt $(\omega \neq 0)$ |
|---|---|---|
| Zeitdauer der Messung | proportional zu der An- zahl der Winkelincre- mente; eine hohe Auflösung führt zu einer grossen Messdauer. | unabhängig von der Win- kelauflösung; sehr kurze Messdauer (ab- hängig von der Rotor- drehzahl). |
| Benötigte Mess- grössen zur Er- Ermittlung des statischen Momentes | * Motorstrom und * Drehmoment-Strom- Charakteristik des Antriebsmotors; * Winkelposition; | zusätzlich: * Gesamtträgheitsmo- ment des Prüfsystems; * Drehzahlabhängigkeit des Reibungsmomentes; * Ermittlung der Winkelge- schwindigkeit und Beschleunigung aus $\varphi(t)$. |
| Unsicherheit des Messresultates | sehr klein; | aufgrund der zusätzlich benötigten Messparameter höhere Unsicherheit. |
| Gesamtaufwand | umfangreichere Hardware; | grösserer Rechenaufwand für die Auswertung. |

*Tabelle : Vergleich zweier Messprinzipien fuer die Erfassung des Stillstands- momentes*

* die direkte Messung des Stillstandsmomentes
$\underline{T_r(\delta)}$, sowie
* die indirekte Bestimmung des Stillstandsmomentes über eine dynamische Drehmomentmessung
(mit $\dot{\omega} \neq 0$).

Die Funktionsblöcke der beiden Varianten sind in den Figuren 4 und 5 einander gegenübergestellt. Ein Vergleich der vorstehenden Tabelle führt zu dem Resultat, daß je nach Schwerpunkt der Prioritäten beide Verfahren ihre Berechtigung haben.

Für die nachfolgende Beschreibung wird das Verfahren der dynamischen Drehmomentmessung gewählt. Weitere Einzelheiten zu dem Prüfstand sind einer Patentanmeldung mit dem Titel "Meß- und Prüfstand für elektromechanishe Wandler" (gleicher Erfinder, gleicher Anmelder, gleicher Anmeldetag) zu entnehmen.

Die Herleitung des Gleichungssystems für die Kompensation des permanentmagnetischen und mechanischen Drehmomentanteils beginnt mit der Darstellung der dynamischen Bewegungsgleichung für das Meßsystem nach Fig. 5. Der Antriebsservomotor wird über eine regelbare Spannungsquelle so gesteuert, daß bei möglichst kleiner Drehzahl die permanentmagnetischen Kippmomente des stromlosen Prüfmotors gerade überwunden werden. Das auftretende Moment läßt sich im stationären Zustand über den Ankerstrom des Antriebsmotors messen.

$$T = f(I(\delta)); \qquad (3\text{ -}2)$$

Für einen DC-Glockenankermotor mit sehr hoher Kollektorlamellenzahl ist der Zusammenhang zwischen Moment und Ankerstrom mit sehr guter Näherung linear. Die Gleichung 3 -2 vereinfacht sich unter der Verwendung der Drehmomentkonstanten $k_T$ zu:

$$T = k_T I(\delta); \qquad (3\text{ -}3)$$

Das meßbare Drehmoment setzt sich aus drei Komponenten zusammen, die im folgenden betrachtet werden.

Den ersten Term bildet das winkelabhängige Drehmoment:

$$T_1 = T_r(\delta); \qquad (3\text{ -}4)$$

Das Rastmoment $T_r$ wird ausgelöst durch eine Überlagerung der permanentmagnetischen Momentschwankungen, der mechanischen Momentschwankungen, sowie des drehzahlunabhängigen Reibungsmomentanteils.

Der zweite Term wird durch drehzahlabhängige Momentanteile bestimmt:

$$T_2 = T_2(\omega) = g(\dot{\delta})\frac{d\delta}{dt}; \qquad (3\text{ -}5)$$

Je nach Motorausführung und Betriebsbereich kann die Funktion $T_2(\omega)$ linear oder auch stark nicht linear von der Drehzahl abhängen. Einflußgrößen sind Lager- und Bürstenreibung, Luftreibung, Wirbelstrom- und Hysteresebremsmomente.

Der dritte Term schließlich ist das Beschleunigungsmoment, abhängig vom Massenträgheitsmoment des gesamten rotierenden Systems.

$$T_3 = T_3(\dot{\omega}) = (J_P + J_b + J_o)\frac{d^2\delta}{d^2t} = J\frac{d^2\delta}{d^2t}; \qquad (\quad 3\text{ —}6)$$

mit

$J_p$:      Trägheitsmoment des Prüfmotors,

$J_b$:    Trägheitsmoment der Bremse,

$J_o$:    sonstige Trägheitsmomente (z.B.Kupplung, Winkelgeber).

Die Drehmomentbilanz aus den Gleichungen ( 3 -2, -4, -5 und -6) lautet somit:

$$f(I(\delta)) = J\frac{d\delta^2}{d^2t} + g(\delta)\frac{d\delta}{dt} + T_r(\delta) ; \qquad (\quad 3 \quad -7)$$

Umgeformt ergibt sich das winkelabhängige Rastmoment zu:

$$T_r(\delta) = f(I(\delta)) - J\frac{d\delta^2}{d^2t} - g(\delta)\frac{d\delta}{dt} ; \qquad (\quad 3 \quad -8)$$

Für die Kompensation der permanetmagnetischen und mechanischen Drehmomentschwankungen ist deshalb folgende Bedingungsgleichung zu erfüllen:

$T_r(\delta) + T_c(\delta) = 0;$    ( 3 -9)

Die Beziehung für die das elektromagnetische Kompensationsmoment $T_c$ erzeugende Phasenströme läßt sich unter Verwendung von Gleichung ( 2 -9) herleiten. Die exakte Lösung unter der Nebenbedingung minimaler Verluste lautet:

$$I_k(\delta) = - \frac{T_r(\delta)\;\omega\;E_k(\delta)}{R_k\;\sum_{\kappa=1}^{m}\frac{E\kappa(\delta)^2}{R\kappa}} ; \qquad (\quad 3 \quad -10)$$

mit $T_r$ ($\delta$) gemäß Gleichung (3 -8).

Wie bei der Kompensation der elektromagnetischen Drehmomentschwankungen kann auch hier alternativ die Stromkurve auf der Grundlage einer harmonischen Analyse ermittelt werden.

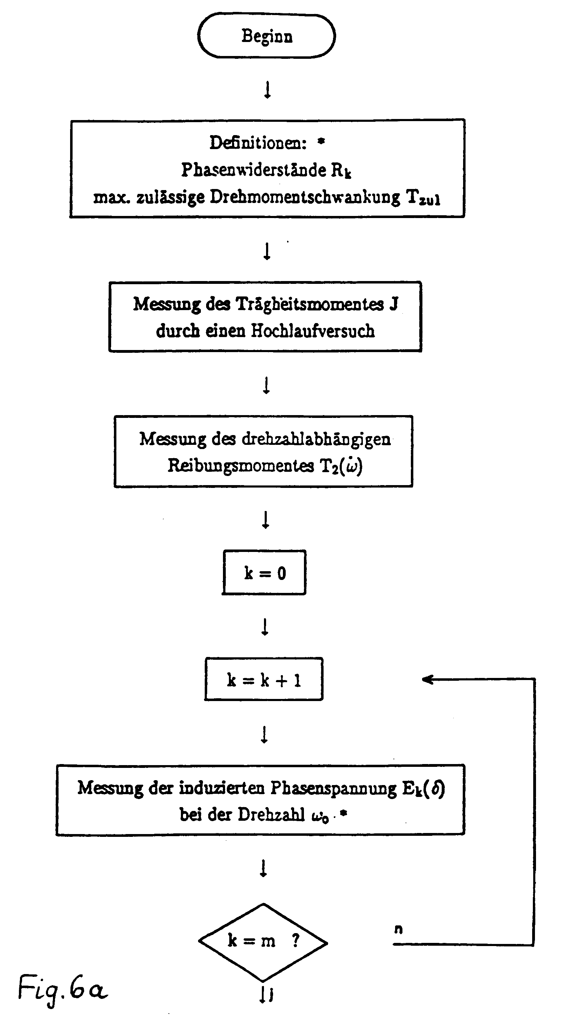

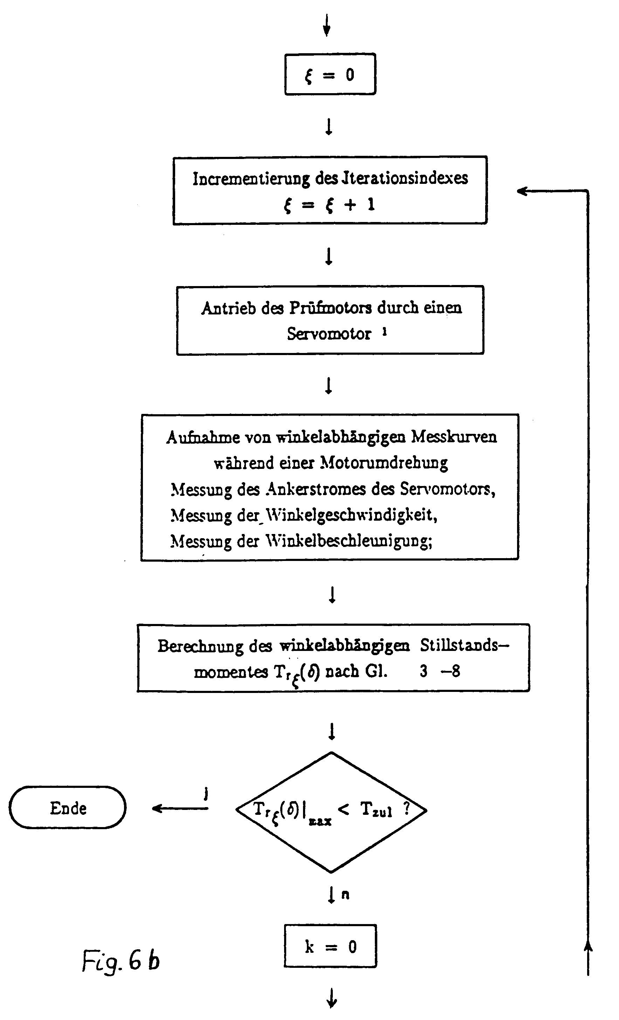

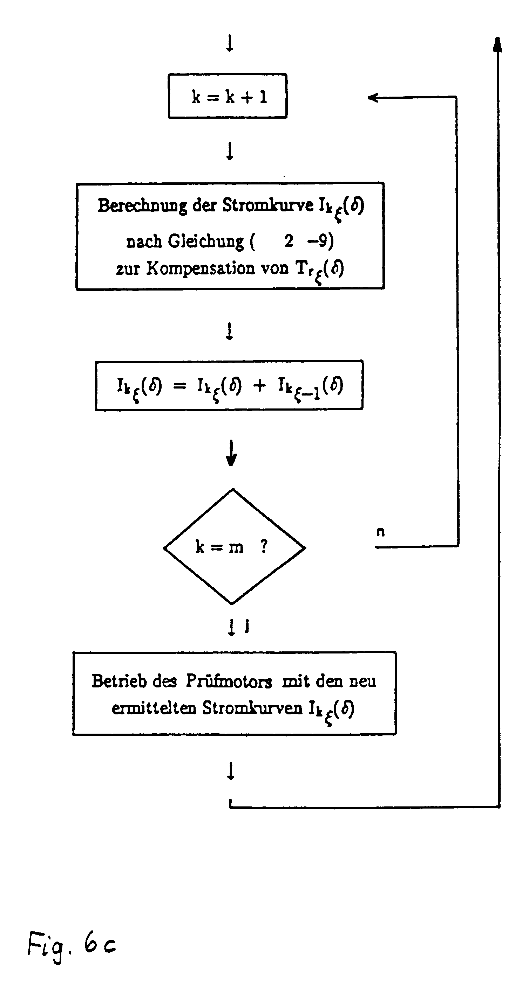

Die Ablauffolge der Berechnung der Phasenstromkurven ist aus dem Flußdiagramm nach Fig. 6 (mit den Teilen Fig. 6a, 6b und 6c) ersichtlich. Die zur Berechnung erforderlichen Messungen am Motor werden auf einem Meß- und Prüfstand vollautomatisch durchgeführt, so daß im Anschluß daran der Motor mit der ermittelten Korrekturkurve betrieben und getestet werden kann.

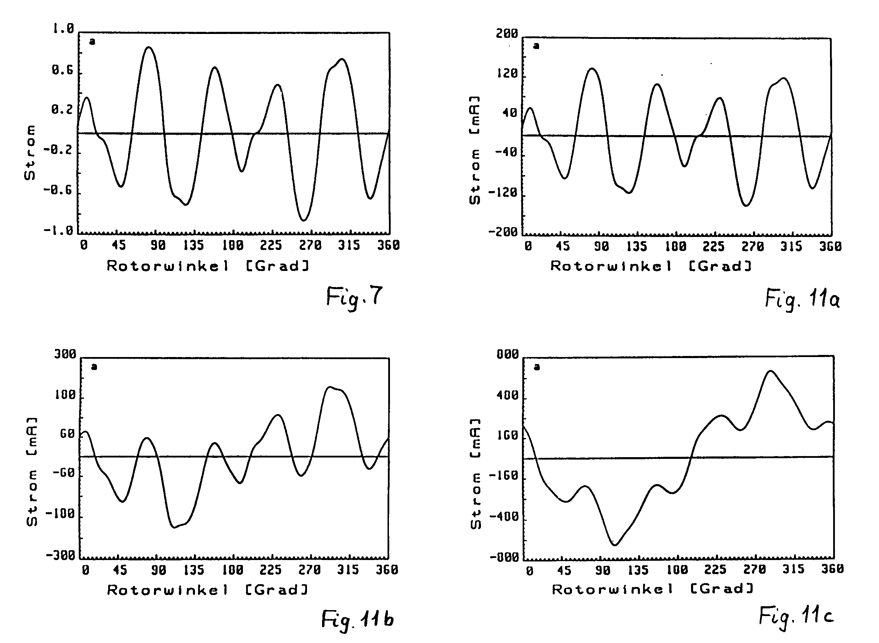

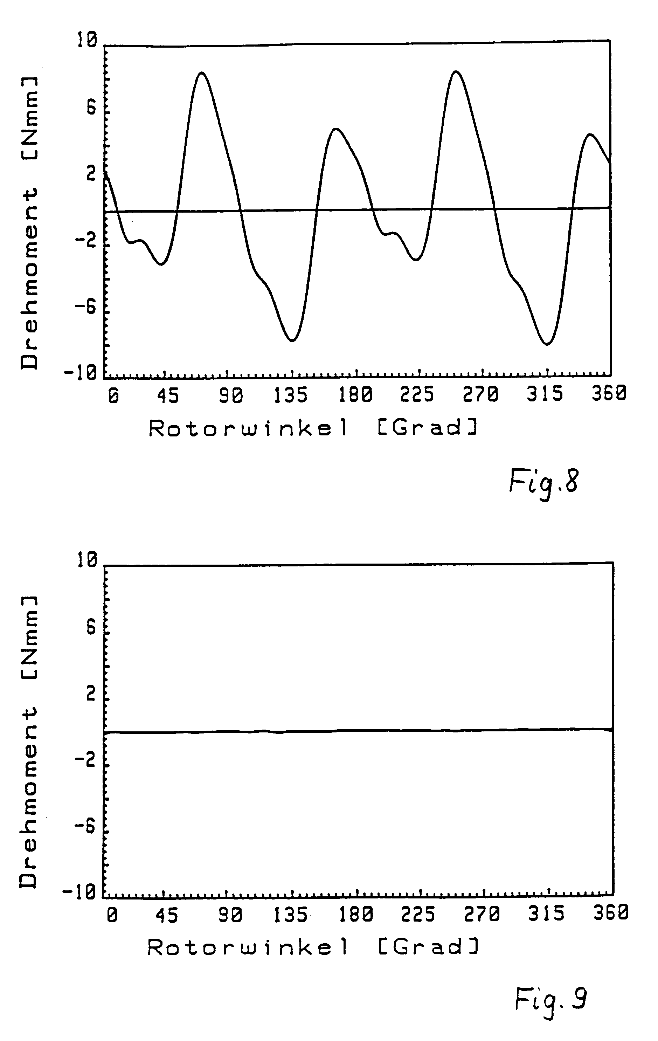

Fig. 7 zeigt für eine Motorphase die in dem iterativen Verfahren nach dem Flußdiagramm nach Fig. 6 ermittelte Stromkurve in normierter Form zur Kompensation von permanentmagnetischen und mechanischen Drehmomentschwankungen. Die Fig. 8 und 9 zeigen Kurven für das Stillstandsdrehmoment vor bzw. nach der elektronischen Korrektur.

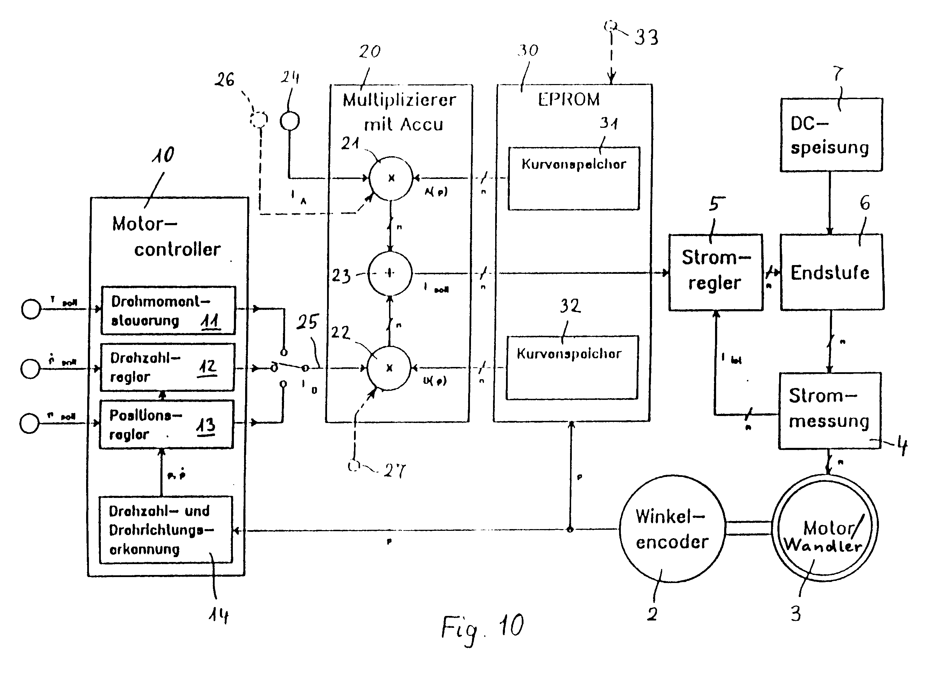

Fig. 10 zeigt nun ein Ausführungsbeispiel in schematischer Darstellung eine Anordnung zur Ansteuerung elektromechanischer Wandler, im vorliegenden Fall eines Elektromotors. Die Schaltungsanordnung nach Fig. 10 enthält einen Motorcontroller 10, eine arithmetische Schaltungseinheit 20, einen Funktionsspeicher 30 sowie eine Leistungsversorgung für den Motor 3, die im vorliegenden Beispiel aus einem Stromregler 5, einer Endstufe 6, einer Gleichspannungsstromversorgung 7 und einer Strommeßvorrichtung 4 besteht. Die arithmetische Schaltungseinheit enthält zwei Multiplizierer 21 und 22 sowie eine Verknüpfungsschaltung in Form eines Akkumulators (Summierers) 23, dessen Ausgangssignal den Stromregler 5 ansteuert. Der Funktionsspeicher 30 enthält im vorliegenden Fall zwei Kurvenspeicher 31 und 32, so daß zwei verschiedene Terme berücksichtigt werden können. Sollten noch weitere Terme, z. B. zur Kompensation von reluktanten oder in andere Richtungen als die Nutzkraft oder das Nutzdrehmoment wirkende

11

Störeinflüsse, verarbeitet werden müssen, so sind die arithmetische Schaltungseinheit 20 und der Funktionsspeicher 30 noch um die entsprechenden Elemente zu erweitern. In einem solchen Fall erfolgen die Verknüpfungen möglicherweise nicht multiplikativ und additiv, wie in Fig. 10 gezeigt, sondern gegebenenfalls durch entsprechende andere funktionelle Verknüpfungen.

Auch wenn in der Schaltungsanordnung nach Fig. 10 in dem Funktionsspeicher 30 pro Einflußgröße nur je ein Speicherabschnitt 31, 32 gezeigt sind, so kann jeder der Speicherabschnitte in mehrere Teile untergliedert sein, damit pro Einflußgröße verschiedene Datensätze gespeichert werden können. Diese verschiedenen Datensätze werden dann durch eine Eingangsgröße 33 ausgewählt.

Der Motorcontroller 10 enthält im vorliegenden Fall eine Drehmomentsteuerung 11, einen Drehzahlregler 12 und einen Positionsregler 13, deren Ausgangssignale über einen Umschalter wahlweise an einen Eingang 25 der arithmetischen Schaltungseinheit 20 gelegt werden, sowie eine Drehzahl- und Drehrichtungserkennung 14. Darüber hinaus ist noch ein Eingang 24 für die arithmetische Schaltungseinheit vorgesehen. Der Motor 3 ist mit einem Winkelencoder 2 gekuppelt, um sowohl für den Funktionsspeicher 30 als auch für den Motorcontroller 10 entsprechende Winkelpositionssignale zu liefern.

Stellvertretend für eine Vielzahl von Korrekturoder Steuergliedern (Eingangsgrößen) ist der Eingang 26 oder 27 gezeichnet für eine mögliche Bewertung der Multiplikationsfaktoren 24 bzw. 25. Die Eingangsgröße 33 entscheidet über die Auswahl spezieller Kurven zur Berücksichtigung verschiedener Betriebszustände (nichtlinearer Betrieb aufgrund Eisensättigung und Ankerrückwirkung, Temperatur) und Motorbetriebsarten (z. B. gleichförmiger Betrieb oder pulsierender Betrieb als Schrittmotor).

Folgende Eingangsgrößen sind für die Schaltungsanordnung interessant: Stellgrößen für die Amplituden der gespeicherten nominierten Kurven oder des Kurvengenerators, gegebenenfalls eine Signalgröße, die das Auslesen der Kurven zeitabhängig oder in Abhängigkeit der Rotorstellung ermöglicht, Steuer- oder Signalgrößen zur Auswahl der Kurven und eventuell zur Veränderung der Kurvenform insbesondere bei nichtlinearer Motorcharakteristik, wo entsprechend dem Betriebszustand die Kurvenform anzupassen ist. Weiterhin können beispielsweise noch Steuergrößen für eine arithmetische Schaltungseinheit 20 auftreten, die den Ablauf der Verknüpfung von Stellgrößen und Kurven steuern oder die Verknüpfungsfunktion entsprechend dem Betriebszustand des Motors ändern. Als Ausgangsgrößen entstehen digitale, analoge oder sonstige Signalgrößen, die gegebenenfalls über einen Leistungssteller, definierte Ströme oder Spannungen den Motorphasen einprägen, um die Rundlaufgüte des Motors oder allgemein die Betriebscharakteristik zu verbessern.

Im Funktionsspeicher 30 sind die Daten für Kurven abgelegt, die zur Kompensation der einzelnen Drehmomentschwankungsarten führen. Die Daten können in Form von Tabellen, Vorschriften (z.B. Begrenzung der maximalen Stromamplitude), Gleichungen oder Funktionen abgespeichert werden. Je nach Symmetrie des magnetischen und elektrischen Kreises ist es nötig, die Kurven für alle Phasen getrennt oder nur je eine Kurve pro Drehmomentschwankungsart abzulegen. Im letzteren Fall werden die Kurven um den Phasenverschiebungswinkel versetzt ausgelesen. An die Stelle der Funktionsspeicher 30 können auch Kurvengeneratoren treten, die die definierten Kurven erzeugen.

Eine arithmetische Schaltungseinheit 20 verknüpft nun die zeit- oder rotorwinkelabhängig zur Verfügung gestellten Kurvenamplituden mit den Eingangsstellgrößen nach definierten Funktionen. Im vorliegenden Fall sind die Verknüpfungsglieder 21, 22 bzw. Addierglieder 23; für die Berücksichtigung anderer Einflußgrößen sind jedoch u. U. andere Verknüpfungen notwendig.

In der Schaltungsanordnung nach Fig. 10 werden die für eine Rotorumdrehung berechneten Stromkurvenwerte der einzelnen Phasen zur Reduktion der elektromagnetischen Drehmomentschwankung (Kurvenspeicher 32) und der Permanentmagnetischen einschließlich der mechanischen Schwankung (Kurvenspeicher 31) getrennt und in normierter Form abgelegt.

Entsprechend dem Rotorwinkel $\phi$ wird die Stromkurve des Kurvenspeichers 31 ausgelesen und mit einer Stromamplitude $i_A$ (Eingang 24) multipliziert. Die Amplitude $i_A$ ist so gewählt, daß die permanentmagnetischen Drehmomentschwankungen minimal werden. Auch die Amplitude $i_A$ ist im abgespeicherten Datesatz enthalten. Bei Motoren mit ungesättigtem Eisenkreis und vernachlässigbarer Ankerrückwirkung kann die Amplitude konstant gehalten werden. Anderenfalls ist der Wert entsprechend den Gegebenheiten nachzuführen. Die auf diese Weise erzeugte Stromkurve fließt unverändert in die einzelnen Phasenwicklungen, unabhängig vom Betriebszustand des Motors und kompensiert somit die permanentmagnetisch und mechanisch verursachten Drehmomentpulsationen.

Unter der Voraussetzung, daß der Motor eine lineare Strom-Drehmomentcharakteristik besitzt, was bei permanentmagneterregten Motoren in der Regel gegeben ist, kann nun der Stromkurve

$$i_{permanent} = i_A \, A(\phi)$$

die eigentliche Betriebskurve additiv überlagert werden. Sie entsteht durch das Produkt aus der Regler-Stromamplitude mit der für die Kompensation der elektromagnetischen Drehmomentschwankungen bestimmten Stromkurve B($\phi$):

$$i_{el-magn} = i_B\, B(\phi)$$

Zeigt der betreffende Motor ein nichtlineares Verhalten, so ist es zweckmäßig, verschiedene Kurven pro Drehmomentschwankungsart für verschiedene Betriebsbereiche einzusetzen. Dies kann beispielsweise dadurch erfolgen, daß man abhängig vom Betriebszustand des Motors einen Kurvenauswahlschalter realisiert, der über einen Eingang 33 die entsprechenden Abschnitte der Speicherabschnitte 31, 32 usw. auswählt. Oder die Kurven werden geeignet verändert, so daß sie besser an den jeweiligen Betriebszustand angepaßt sind. Eine Anpassung kann aber auch über eine Veränderung der Eingangsstellgrößen 26, 27 erfolgen.

Für den Fall, daß die reluktanten Drehmomentschwankungen oder noch andere Einflüsse nicht vernachlässigbar sind, kann der Schaltung nach Fig. 10 noch ein dritter Pfad oder noch weitere Pfade, bestehend aus einem zusätzlichen Speicherabschnitt und einem Verknüpfungsglied (nicht gezeigt), hinzugefügt werden, der die Reduktion der reluktanten Schwankungen durch entsprechende Stromverläufe erlaubt.

Aus der eingangs angeführten Drehmomentengleichung geht hervor, daß dieser Term von den Selbst- und Gegeninduktivitäten sowie von den einzelnen Phasenströmen abhängig sein kann. Es ist möglich, die nötige Information für die Stromkurvengenerierung als Datensätze in Form von Tabellenwerten, Vorschriften, Gleichungen oder Funktionen abzulegen, oder die Information direkt aus dem jeweiligen Betriebszustand zu errechnen.

Die Realisation der elektrischen Schaltung kann auf verschiedene Weisen erfolgen. Sie kann beispielsweise rein hardwaremäßig aus analogen und/oder digitalen Bausteinen aufgebaut sein, oder sie kann auch softwaremäßig durch ein Rechnerprogramm realisiert werden. Der elektrischen Schaltung kann nun zusätzlich eine Momentensteuerung, sowie eine Positions-, Drehzahl- oder Beschleunigungsregelung überlagert werden. Im gezeigten Fall hat die Gesamtschaltung die Struktur einer Kaskadenregelung. Dem Positionsregler 13 ist im Motorcontroller 10 intern ein Drehzahlregler 12 und diesem extern ein Stromregler 5 unterlagert.

Der wesentliche Unterschied zu anderen Positions-, Drehzahl-, Beschleunigungs- und Momentenregelungen liegt darin begründet, daß aufgrund der gewählten Stromkurvensteuerung eventuelle Momentenschwankungen bereits im Ansatz unterdrückt und somit die überlagerten Regelkreise sehr stark entlastet werden. Die Regler sind lediglich noch für eine Feinkorrektur auszulegen. Für die Einprägung eines Drehmomentes kann ein Regler ganz entfallen.

Durch diese vorgestellten Maßnahmen wird das Betriebsverhalten des Motors bezüglich Momenten- und somit auch Drehzahlschwankungen wesentlich verbessert. Weitere Verbesserungen sind geringere Geräuschentwicklung, bessserer Wirkungsgrad und geringere Betriebstemperaturen.

Die vorgeschlagene elektronische Schaltung eignet sich zur Ansteuerung von Motoren mit beliebigen Stromkurven. Fügt man parallel zum Winkelencoder 2 einen zusätzlichen in der Frequenz steuerbaren Pulsgenerator hinzu, so eignet sich diese Schaltung für den universellen Betrieb von allen elektrischen Kleinmotorenarten, also auch für fremdgesteuerte und nicht positionsgesteuerte Motoren, wie allgemeine Synchronmotoren, Schrittmotoren, Asynchronmotoren etc. Für den rückgekoppelten Betrieb schaltet man den Winkelencoder 2 und für den gesteuerten Betrieb den Pulsgenerator in den elektrischen Kreis.

Die Fig. 11a, 11b und 11c zeigen nun für eine Phase Stromkurven zur Erzielung verschiedener Konstant-Nenndrehmomente, wie sie z.B. mittels der Schaltungsanordnung nach Fig. 10 an den Motor 3 gelegt werden. Diese Kurven berücksichtigen beide Anteile von Drehmomentschwankungen, nämlich die elektromagnetischen und die permanentmagnetischen Schwankungen. Es werden Phasenstromkurven für drei verschiedene Betriebszustände des Motors 3 gezeigt, und zwar für den stromlosen Zustand (Fig. 11a) für einen Stom von 0,1 A (Fig. 11b) und für einen Strom von 0,5 A (Fig. 11c). Es ergibt sich dabei ein sehr gleichmäßiger Drehmomentverlauf ohne Schwankungen.

Literaturverzeichnis

1. Hanitsch, R., Lindner, J.
Scheibenläufermotoren mit Seltenerdmagneten,Techn.Rundschau, 14. Juni 1983
2. N.N.
General Purpose Motion Control IC: HCTL 1000, Druckschrift der Firma Hewlett Packard, Nov. 1985

EP 0 448 610 B1

3. Braun, W.

Die harmonische Steuerung von selbstgeführten Wechselrichtern zur Speisung von Käfigläufermotoren mit Unterdrückung der massgebenden Stromoberschwingungen, Diss. Universität Stuttgart, 1972

4. Le-Huy, Perret, Feuillet

Minimization of Torque Ripple in Brushless DC-Motor Drives, Industry Applications, IEEE, 28/1985

5. Bolton, H., Ashen, R.

Influence of Motor Design and Feed-Current Waveform on Torque Ripple in Brushless DC-Drives, IEE Proceedings, Vol. 131, No. 3, May 1984

6. Grotstollen, H.

Die Unterdrueckung der Oberwellendrehmomente von Synchronmotoren durch Speisung mit oberschwingungsbehaftetem Strom, Archiv fuer Elektrotechnik, 67 (1984)

7. Weschta, A.

Pendelmomente von permanentmagneterregten Synchron-Servomotoren, etz Archiv, Bd. 5(1983) H. 4

8. Schröder, M.

Einfach anzuwendendes Verfahren zur Unterdrückung der Pendelmomente dauermagneterregter Synchronmaschinen, etz Archiv, Bd. 10 (1988) H. 1

9. Schröder, M.

Hochtouriger bürstenloser Positionierantrieb mit extrem geringer Momenten-welligkeit, Diss., Universität Stuttgart, 1986

**Patentansprüche**

1.  Verfahren zur Ansteuerung elektromechanischer Wandler zwecks Erzeugung eines vorgegebenen Kraftbzw. Drehmomentverlaufs, insbesondere zur Verminderung winkelabhängiger Drehmomentschwankungen in Elektromotoren,
    bei dem in einem Funktionsspeicher (30) zeit- oder positionsabhängige (weg- bzw. drehwinkelabhängige) Datensätze gespeichert werden, die abhängig vom im Betrieb zurückgelegten Weg bzw. Drehwinkel oder zeitgesteuert abgerufen und in einer arithmetischen Schaltungseinheit (20) mit einer Eingangsgröße zu Augenblickswerten verknüpft werden, und
    bei dem abhängig von den Augenblickswerten Spannungen oder Ströme mit entsprechender zeit- oder positionsabhängiger Kurvenform in die elektrischen Anschlüsse des Wandlers (3) eingeprägt werden,
    dadurch gekennzeichnet, daß in dem Funktionsspeicher (30) mehrere verschiedene, aus dem Kraftbzw. Drehmomentverlauf des Wandlers (3) und gegebenenfalls einer angeschlossenen Last ermittelte verschiedene Einflüsse berücksichtigende Datensätze, insbesondere in Form von Tabellen, Vorschriften,
    Gleichungen oder Funktionen gespeichert werden, daß diese Datensätze positionsabhängig oder zeitabhängig aus dem Funktionsspeicher (30) abgerufen und getrennt nach den Einflüssen satzweise mit mindestens je einer Eingangsgröße (24,25,26,27) verknüpft werden, und
    daß diese so erhaltenen Verknüpfungsergebnisse zu den positions- bzw. zeitabhängigen Augenblickswerten zusammengesetzt werden.

2.  Verfahren nach Anspruch 1 zur Ansteuerung elektromagnetischer Wandler (3),
    dadurch gekennzeichnet, daß wenigstens zwei der nachfolgenden, den Kraft- bzw. Drehmomentverlauf des Wandlers (3) und gegebenenfalls der angeschlossenen Last beeinflussende Größen berücksichtigt werden:
    a) elektromagnetische Einflüsse,
    b) reluktante Einflüsse,
    c) permanentmagnetische Einflüsse,
    d) mechanische Einflüsse (im Wandler und gegebenenfalls auch der angeschlossenen Last).

3.  Verfahren zur Ansteuerung elektromagnetischer Wandler zwecks Erzeugung eines vorgegebenen Kraftbzw. Drehmomentverlaufs, insbesondere zur Verminderung winkelabhängiger Drehmomentschwankungen in Elektromotoren,
    bei dem in einem Funktionsspeicher (30) positionsabhängige (weg- bzw. drehwinkelabhängige) Datensätze gespeichert werden, die abhängig vom im Betrieb zurückgelegten Weg bzw. Drehwinkel oder zeitgesteuert abgerufen und in einer arithmetischen Schaltungseinheit (20) mit einer Eingangsgröße zu Augenblickswerten verknüpft werden, und
    bei dem abhängig von den Augenblickswerten Spannungen oder Ströme mit entsprechender zeit- oder

14

positionsabhängiger Kurvenform in die elektrischen Anschlüsse des Wandlers (3) eingeprägt werden, dadurch gekennzeichnet, daß in dem Funktionsspeicher (30) ein aus dem Kraft- bzw. Drehmomentverlauf des Wandlers (3) ermittelter, die permanentmagnetischen Einflüsse des Wandlers berücksichtigender Datensatz gespeichert wird, daß dieser Datensatz positionsoder zeitabhängig aus dem Funktionsspeicher (30) abgerufen und mit mindestens einer Eingangsgröße (24,25,26,27) verknüpft wird, und daß diese so erhaltenen Verknüpfungsergebnisse die positions- bzw. zeitabhängigen Augenblickswerte darstellen.

4. Verfahren zur Ansteuerung elektromechanischer Wandler (3) zwecks Erzeugung eines vorgegebenen Kraft- bzw. Drehmomentverlaufs, insbesondere zur Verminderung winkelabhängiger Drehmomentschwankungen in Elektromotoren,
bei dem in einem Funktionsspeicher (30) positionsabhängige (weg- bzw. drehwinkelabhängige) Datensätze gespeichert werden, die abhängig vom im Betrieb zurückgelegten Weg bzw. Drehwinkel oder zeitgesteuert abgerufen und in einer arithmetischen Schaltungseinheit (20) mit einer Eingangsgröße zu Augenblickswerten verknüpft werden, und
bei dem abhängig von den Augenblickswerten Spannungen oder Ströme mit entsprechender zeit- oder positionsabhängiger Kurvenform in die elektrischen Anschlüsse des Wandlers (3) eingeprägt werden, dadurch gekennzeichnet, daß in dem Funktionsspeicher ein aus dem Kraft- bzw. Drehmomentverlauf des Wandlers und gegebenenfalls der angeschlossenen Last ermittelter, die mechanischen Einflüsse berücksichtigender Datensatz positions- oder zeit-abhängig aus dem Funktionsspeicher abgerufen und mit mindestens einer Eingangsgröße (24,25,26) verknüpft wird, und daß diese so erhaltenen Verknüpfungsergebnisse die positions- bzw. zeitabhängigen Augenblickswerte darstellen.

5. Verfahren nach einem der Ansprüche 1 bis 4,
dadurch gekennzeichnet, daß nicht nur eine Einprägung von Strom- oder Spannungskomponenten für die gewünschte Nutzkraft bzw. für das Nutzmoment erfolgt, sondern zusätzlich auch eine Einprägung von Strom- oder Spannungskomponenten für die Kompensation von Störkräften oder Störmomenten, deren Richtungen sich von der Richtung der Nutzkraft bzw. des Nutzmomentes unterscheiden.

6. Verfahren nach Anspruch 5 für einen Elektromotor (3),
dadurch gekennzeichnet, daß die Einprägung dieser die Störkräfte bzw. Störmomente in anderen Richtungen berücksichtigenden Spannungen oder Ströme wenigstens zum Teil über Zusatzwicklungen erfolgt.

7. Verfahren nach einem der Ansprüche 1 bis 6,
dadurch gekennzeichnet, daß die den Kraft- bzw. Drehmomentverlauf des Wandlers (3) und gegebenenfalls der Last berücksichtigenden Datensätze nur aus den gegebenen Konstruktions und Materialdaten berechnet werden.

8. Verfahren nach einem der Ansprüche 1 bis 6,
dadurch gekennzeichnet, daß die den Kraft- bzw. Drehmomentverlauf des Wandlers (3) und gegebenenfalls der Last berücksichtigenden Datensätze aus an einem Muster gemessenen Parametern und/oder Kennlinien berechnet werden.

9. Verfahren nach einem der Ansprüche 1 bis 6,
dadurch gekennzeichnet, daß die den Kraft- bzw. Drehmomentverlauf des Wandlers (3) und gegebenenfalls der Last berücksichtigenden Datensätze durch Meßläufe zur Optimierung zwecks Erreichens des vorgegebenen Kraft- bzw. Drehmomentverlaufs eines Musters auf einem Meß- und Prüfstand ermittelt werden.

10. Verfahren nach Anspruch 7, 8 oder 9 in Verbindung mit Anspruch 2 oder 4,
dadurch gekennzeichnet, daß zusätzlich zu den Einflüssen des Wandlers (3) noch die Einflüsse einer mit dem Wandler gekuppelten Last berücksichtigt werden.

11. Verfahren nach einem oder mehreren der Ansprüche 1 bis 10,
dadurch gekennzeichnet, daß mindestens eine der Eingangsgrößen (24,25,26,27) eine Konstante oder bei Betriebszuständen wie nichlineare Wandlercharakteristik, Eisensättigung, Ankerrückwirkung etc. eine diesen Effekten angepaßte Größe ist.

**12.** Verfahren nach einem oder mehreren der Ansprüche 1 bis 10,
dadurch gekennzeichnet, daß mindestens eine der Eingangsgrößen (24,25,26,27) eine Fuhrungsgröße, z.B. für eine Kraft-, Momenten-, Drehzahl-, Beschleunigungs- und/oder Positionsregelung bzw. -steuerung, ist.

**13.** Verfahren nach 11 oder 12,
dadurch gekennzeichnet, daß die Eingangsgrößen (24,25,26,27) umschaltbar sind.

**14.** Verfahren nach einem oder mehreren der vorstehenden Ansprüche,
dadurch gekennzeichnet, daß pro Einfluß mehrere Datensätze vorgesehen sind, die durch eine weitere Eingangsgröße (26,27) abhängig vom Betriebszustand, insbesondere zur Berücksichtigung von nichtlinearer Wandlercharakteristik, Eisensättigung, Ankerrückwirkung etc., und/oder zur Änderung des Betriebsverhaltens des Wandlers (3) auswählbar sind.

**15.** Anordnung zur Durchführung des Verfahrens nach einem oder mehreren der vorstehenden Ansprüche,
gekennzeichnet durch einen Funktionsspeicher (30) mit je einem Speicherabschnitt (31,32) pro zu berücksichtigenden einem Speicherabschnitt (31,32) pro zu berücksichtigenden Einfluß zur Speicherung des zugeordneten Datensatzes,
eine arithmetische Schaltungseinheit (20) zum Verknüpfen von aus den Speicherabschnitten ausgelesenen Datensätzen mit je mindestens einer Eingangsgröße (24,25,26) und zum Zusammenfassen der Verknüpfungsergebnisse zu Augenblickswerten,
einen dem elektromechanischen Wandler (3) zugeordneten Positions- oder Zeitgeber (2) zur Steuerung des positions- oder zeitabhängigen Auslesens der Daten im Funktionsspeicher, und
einen Leistungssteller (6) zum Einprägen von Spannungen oder Strömen in die elektrischen Anschlüsse des Wandlers (3) entsprechend den Augenblickswerten.

**16.** Anordnung nach Anspruch 15,
dadurch gekennzeichnet, daß die arithmetische Schaltungseinheit (20) Multiplicationsglieder (21,22) Verknüpfen tungseinheit (20) Multiplikationsglieder (21,22) zum Verknüpfen der ausgelesenen Datensätze mit jeweils mindestens einer Eingangsgröße (24,25,26,27) sowie Additions-/Subtraktionsglieder (23) zum unbewerteten oder bewerteten Zusammenfassen der Multiplikationsergebnisse enthält.

**17.** Anordnung nach Anspruch 15 oder 16 für einen mehrphasigen Wandler (3),
dadurch gekennzeichnet, daß für jede der einzelnen Phasen entsprechende Datensätze abgespeichert sind und in Verbindung mit den Eingangsgrößen (24,25,26,27) entsprechende Augenblickswerte abgeleitet werden, und
daß für jede der einzelnen Phasen entsprechende Funktionsspeicher (30), arithmetische Schaltungseinheiten (20) und Leistungssteller (6) vorgesehen sind oder diese im Zeitmultiplex betrieben werden.

**18.** Anordnung nach Anspruch 15 oder 16 für einen mehrphasigen Wandler (3),
dadurch gekennzeichnet, daß für alle Phasen gemeinsame Datensätze abgespeichert sind, und
daß für die einzelnen Phasen diese Datensätze phasenversetzt ausgelesen und durch die arithmetische(n) Schaltungseinheit(en) (20) in Verbindung mit den Eingangsgrößen (24,25,26,27) zu Augenblickswerten für die einzelnen Phasen verknüpft werden.

**19.** Anordnung nach Anspruch 15 oder 16 für einen mehrphasigen Wandler (3),
dadurch gekennzeichnet, daß für alle Phasen gemeinsame Datensätze abgespeichert und aus diesen gemeinsame Augenblickswerte abgeleitet werden, und
daß eine Phasenschiebereinheit vorgesehen ist, die aus den gemeinsamen Augenblickswerten die um die entsprechenden Phasenwinkel verschobenen Augenblickswerte für alle Phasen ableitet.

**Claims**

**1.** A process for controlling electromagnetic transformers for the purpose of producing a predetermined power and moment of rotation characteristic, in particular for the reduction of angle-dependent moment of rotation fluctuations in electric motors,
in which in a function memory (30) are stored time-dependent or position-dependent (dependent on the path and angle of rotation) data sets, which are fetched in dependence on the path and angle of rotation covered in operation or in a time-controlled manner and in an arithmetic switching unit (20) are connected to an input variable to provide instantaneous values,

in which in dependence on the instantaneous values voltages or currents having a corresponding time-dependent or position-dependent curve shape are inputted into the electrical connections of the transformer (3),

**characterised in that** in the function memory (30) are stored several different data sets taking into consideration different influences determined from the power and moment of rotation characteristic of the transformer (3) and if necessary of a connected load, in particular in the form of tables, rules, equations or functions,

**in that** these data sets are fetched from the function memory (30) in dependence on position or time and are separately connected according to the influences in sets to at least one input variable (24, 25, 26, 27),

**and in that** these connecting results obtained in this manner are collated to form the position- and time-dependent instantaneous values.

2. A process according to Claim 1 for controlling electromagnetic transformers (3),

**characterised in that** at least two of the subsequent variables influencing the power and moment of rotation characteristic of the transformer (3) and if necessary the connected load are taken into consideration:

    a) electromagnetic influences,

    b) reluctance influences,

    c) permanent magnetic influences,

    d) mechanical influences (in the transformer and if necessary also the connected load).

3. A process for controlling electromagnetic transformers for the purpose of producing a predetermined force and moment of rotation characteristic, in particular for the reduction of angle-dependent moment of rotation fluctuations in electric motors,

in which in a function memory (30) are stored position-dependent (dependent on the path and angle of rotation) data sets, which are fetched in dependence on the path and angle of rotation in operation or in a time-controlled manner and in an arithmetic switching unit (20) are connected to an input variable to provide instantaneous values, and

in which in dependence on the instantaneous values voltages or currents having corresponding time- or position-dependent curve shape are inputted into the electrical connections of the transformer (3),

**characterised in that** in the function memory (30) is stored a data set, which is determined from the power and moment of rotation characteristic of the transformer (3) and takes into consideration the permanent magnetic effects of the transformer,

**in that** this data set is fetched from the function memory (30) in a position-dependent or time-dependent manner and is connected to at least one input variable (24, 25, 26, 27),

**and in that** the connection results obtained in this manner represent the position-dependent and time-dependent instantaneous values.

4. A process for controlling electromechanical transformers (3) for the purpose of producing a predetermined force and moment of rotation characteristic, in particular for the reduction of angle-dependent moment of rotation fluctuations in electric motors,

in which in a function memory (30) are stored position-dependent (dependent on the path and the angle of rotation) data sets, which are fetched in dependence on the path and angle of rotation covered in operation or in a time-controlled manner and in an arithmetical switching unit (20) are connected to an input variable to provide instantaneous values, and

in which in dependence on the instantaneous values voltages or currents having corresponding time- or position-dependent curve shape are inputted into the electrical connections of the transformer (3),

**characterised in that** in the function memory a data set, which is determined from the force and moment of rotation characteristic of the transformer and if necessary the connected load, and which takes into consideration the mechanical influences, is fetched in dependence on position on time from the function memory and is connected to at least one input variable (24, 25, 26),

**and in that** these connection results obtained in this manner represent the position- and time-dependent instantaneous values.

5. A process according to one of Claims 1 to 4,
   **characterised in that** not only an input of current or voltage components for the desired useful power or for the useful moment occurs, but in addition an input of current or voltage components occurs for the compensation of disturbance powers or moments, the directions of which differ from the direction of the useful power and useful moment respectively.

6. A process according to Claim 5 for an electric motor (3),
   **characterised in that** the input of these voltages or currents taking into consideration the disturbance powers or moments in other directions is performed at least partly via auxiliary windings.

7. A process according to one of Claims 1 to 6,
   **characterised in that** the data sets taking into consideration the power and moment of rotation characteristic of the transformer (3) and if necessary of the load are only calculated from the given constructional and material data.

8. A process according to one of Claims 1 to 6,
   **characterised in that** the data sets taking into consideration the power and moment of rotation characteristic of the transformer (3) and if necessary of the load are calculated from parameters and/or characteristic curves measured on a model.

9. A process according to one of Claims 1 to 6,
   **characterised in that** the data sets taking into consideration the power and moment of rotation characteristic of the transformer (3) and if necessary the load are determined by test runs for optimisation for the purpose of achieving the predetermined power and moment of rotation characteristic of a model on a measuring and test stand.

10. A process according to Claim 7, 8 or 9 in conjunction with Claim 2 or 4,
    **characterised in that** in addition to the influences of the transformer (3) the influences of a load coupled with the transformer are further taken into consideration.

11. A process according to one or more of Claims 1 to 10,
    **characterised in that** at least one of the input variables (24, 25, 26, 27) is a constant or in operating states such as non-linear transformer characteristic, iron saturation, armature reaction, etc is a variable adapted to these effects.

12. A process according to one or more of Claims 1 to 10,
    **characterised in that** at least one of the input variables (24, 25, 26, 27) is a command variable, e.g. for a power, moment, moment of rotation, acceleration and/or position regulation or control.

13. A process according to Claim 11 or 12,
    **characterised in that** the input variables (24, 25, 26, 27) can be switched over.

14. A process according to one or more of the preceding Claims,
    **characterised in that** several data sets are provided per influence, which can be selected by a further input variable (26, 27) in dependence on the operating state, in particular to take into consideration non-linear transformer characteristics, iron saturation, armature reaction, etc, and/or to change the operational behaviour of the transformer (3).

15. An arrangement for performing the process according to one or more of the preceding Claims,
    **characterised by** a function memory (30) having one memory section (31, 32) per influence to be taken into consideration for the storage of the associated data set,
    an arithmetical switching unit (20) for connecting data sets read out of the memory sections with at least one input variable (24, 25, 26) and for collating the connection results to provide instantaneous values,
    a position or timing unit (2) associated with the electromechanical transformer (3) for controlling the position-dependent and time-dependent reading-out operation of the data in the function memory, and
    an output stage (6) for inputting voltages or currents into the electrical connections of the transformer (3) corresponding to the instantaneous values.

EP 0 448 610 B1

16. An arrangement according to Claim 15,
   **characterised in that** the arithmetical switching unit (20) contains multiplication elements (21, 22) for connecting the read-out data sets with at least one input variable (24, 25, 26, 27) and also addition/subtraction elements (23) for the nonevaluated or evaluated collation of the multiplication results.

17. An arrangement according to Claim 15 or 16 for a multi-phase transformer (3),
   **characterised in that** for each of the individual phases are stored corresponding data sets and in conjunction with the input variables (24, 25, 26, 27) corresponding instantaneous values are derived,
   **and in that** for each of the individual phases corresponding function memories (30), arithmetic switching units (20) and power output stages (6) are provided or they are operated in the time multiplex.

18. An arrangement according to Claim 15 or 16 for a multi-phase transformer (3),
   **characterised in that** data sets common to all phases are stored,
   **and in that** for the individual phases these data sets are read out with phase shifting and are connected by the arithmetical switching units (20) in conjunction with the input variables (24, 25, 26, 27) to provide instantaneous values for the individual phases.

19. An arrangement according to Claim 15 or 16 for a multiphase transformer (3),
   **characterised in that** data sets common to all phases are stored and from them are derived common instantaneous values,
   **and in that** a phase shift unit is provided, which from the common instantaneous values derives the instantaneous values for all phases shifted by the corresponding phase angle.

**Revendications**

1. Procédé de commande de convertisseurs électromécaniques pour obtenir un profil prédéterminé de force ou de couple, notamment pour réduire les variations de couple de rotation dépendant de l'angle, dans les moteurs électriques,
   - selon lequel on enregistre dans une mémoire de fonction (30) des jeux de données dépendant du temps ou de la position (dépendant de la course ou de l'angle de rotation), jeux qui dépendent de la course ou de l'angle parcouru pendant le fonctionnement ou qui sont appelés de manière commandée dans le temps pour être combinés par une unité arithmétique (20) avec une grandeur d'entrée pour former les valeurs instantanées et
   - selon lequel, en fonction des valeurs instantanées on applique des tensions ou des intensités avec des formes de courbes correspondantes dépendant du temps ou de la position aux bornes électriques du convertisseur (3),
   procédé caractérisé en ce que la mémoire de fonction (30) contient plusieurs jeux de données différents obtenus à partir du profil de la force ou du couple du convertisseur (3) et le cas échéant d'une charge reliée en tenant compte de différentes influences, jeu de données notamment sous la forme de tableaux de prescriptions, d'équations ou de fonctions,
   - ces jeux de données sont appelés en fonction de la position ou en fonction du temps dans la mémoire de fonction (30) et sont combinés séparément selon les influences, par jeux avec chaque fois au moins une grandeur d'entrée (24, 25, 26, 27) et ces résultats de combinaisons ainsi obtenus sont réunis aux valeurs instantanées dépendant de la position ou du temps.

2. Procédé selon la revendication 1 pour la commande de convertisseurs électromagnétiques (3),
   caractérisé en ce que
   on tient compte d'au moins deux grandeurs suivantes influençant le profil de la force ou du couple du convertisseur (3) et le cas échéant de la charge raccordée :
   a) influence électromagnétique,
   b) influence réluctante,
   c) influence par aimant permanent,
   d) influence mécanique (convertisseur et le cas échéant également charge raccordée).

3. Procédé de commande d'un convertisseur électromagnétique pour créer un profil prédéterminé de force ou de couple, notamment pour réduire les variations de couple dépendant de l'angle dans des moteurs électriques,

19

- selon lequel une mémoire de fonction (30) contient des jeux de données dépendant de la position (course ou angle de rotation) et qui ont été appelés en dépendance de la course ou de l'angle de rotation parcouru pendant le fonctionnement ou commandés en fonction du temps, et qui sont combinés dans une unité arithmétique (20) d'une grandeur d'entrée pour former des valeurs instantanées et

- selon lequel, en fonction des valeurs instantanées on applique des tensions ou des intensités à courbe de forme correspondante dépendant du temps ou de la position dans les bornes électriques du convertisseur (3),

- procédé caractérisé en ce que dans la mémoire de fonction (30) on enregistre un jeu de données déterminé à partir du profil de la force ou du couple du convertisseur (3), et tenant compte des influences d'aimantation permanente du convertisseur, on appelle ce jeu de données dans la mémoire de fonction (30) en dépendance de la position ou du temps et on combine avec au moins une grandeur d'entrée (24, 25, 26, 27) et

- les résultats obtenus des combinaisons représentent les valeurs instantanées dépendant de la position ou du temps.

4. Procédé de commande de convertisseurs électromécaniques (3) pour créer un profil prédéterminé de force ou de couple, notamment pour réduire les variations de couple des moteurs électriques dépendant de l'angle,

- selon lequel on enregistre dans une mémoire de fonction (30) des jeux de données dépendant de la position (dépendant de la course ou de l'angle de rotation), ces jeux étant appelés en fonction de la course ou de l'angle parcouru pendant le fonctionnement ou de manière commandée dans le temps et sont combinés à une grandeur d'entrée dans une unité arithmétique (20) pour former des valeurs instantanées, et

- selon lequel, en fonction de la valeur instantanée des tensions et des intensités on applique aux bornes électriques du convertisseur (3) des tensions ou intensités avec des profils de courbe correspondants, dépendant du temps ou de la position,

procédé caractérisé en ce qu'on appelle dans la mémoire de fonction, selon la position ou le temps, un jeu de données obtenu à partir du profil, de la force ou du couple du convertisseur et le cas échéant de la charge raccordée et qui tient compte des influences mécaniques et on combine ce jeu à au moins une grandeur d'entrée (24, 25, 26) et les résultats ainsi obtenus de la combinaison représentent les valeurs instantanées dépendant de la position ou du temps.

5. Procédé selon l'une des revendications 1 à 4, caractérisé en ce que l'on applique non seulement des composantes d'intensité ou de tension pour la force souhaitée ou pour le couple utile mais en plus on applique des composantes d'intensité ou de tension pour compenser les forces parasites ou les couples parasites dont la direction se distingue de la direction de la force utile ou du couple utile.

6. Procédé selon la revendication 5 pour un moteur électrique (3), caractérisé en ce qu'on applique les tensions ou les intensités tenant compte de ces forces ou couples parasites dans d'autres directions, au moins en partie par des enroulements supplémentaires.

7. Procédé selon l'une des revendications 1 à 6, caractérisé en ce que les jeux de données tenant compte du profil, des forces ou du couple du convertisseur (3) et le cas échéant de la charge ne sont calculés qu'à partir de données de construction ou de matériaux.

8. Procédé selon l'une des revendications 1 à 6, caractérisé en ce que les jeux de données tenant compte du profil, de la force ou du couple du convertisseur (3) et le cas échéant de la charge sont calculés à partir de paramètres et/ou de courbes caractéristiques mesurés sur un modèle.

9. Procédé selon l'une des revendications 1 à 6, caractérisé en ce que les jeux de données tenant compte du profil, de la force ou du couple du convertisseur (3) et le cas échéant de la charge sont obtenus par des parcours de mesure pour optimiser un profil prédéterminé de force ou de couple d'un modèle dans un poste de mesures et d'essais.

10. Procédé selon l'une des revendications 7, 8 ou 9 en combinaison avec la revendication 2 ou 4, caractérisé en ce qu'en plus des influences du convertisseur (3) on tient également compte des influences d'une charge couplée au convertisseur.

**11.** Procédé selon une ou plusieurs des revendications 1 à 10, caractérisé en ce qu'au moins l'une des grandeurs d'entrée (24, 25, 26, 27) est une constante ou une grandeur adaptée aux effets pour des états de fonctionnement correspondant à une caractéristique non linéaire de convertisseur, la saturation du fer, l'excitation en retour de l'induit, etc...

**12.** Procédé selon une ou plusieurs des revendications 1 à 10, caractérisé en ce qu'au moins l'une des grandeurs d'entrée (24, 25, 26, 27) est une grandeur guide par exemple une régulation ou commande de force, de couple, de vitesse de rotation, d'accélération et/ou de position.

**13.** Procédé selon la revendication 11 ou 12, caractérisé en ce que les grandeurs d'entrée (24, 25, 26, 27) peuvent être commutées.

**14.** Procédé selon une ou plusieurs des revendications précédentes, caractérisé en ce que l'on a plusieurs jeux de données par influence qui sont choisis par une autre grandeur d'entrée (26, 27) selon l'état de fonctionnement, notamment pour tenir compte d'une caractéristique non linéaire du convertisseur, de la saturation du fer, de la réaction de l'induit, etc...et/ou pour modifier le comportement en fonctionnement du convertisseur (3).

**15.** Montage pour la mise en oeuvre du procédé selon une ou plusieurs des revendications précédentes, caractérisé par une mémoire de fonction (30) comprenant chaque fois une zone de mémoire (31, 32) pour toute influence à prendre en compte, pour enregistrer le jeu de données correspondant,
- une unité arithmétique (20) pour combiner des jeux de données lues dans les zones de mémoire avec au moins une grandeur d'entrée (24, 25, 26) et pour réunir les résultats de la combinaison et former des valeurs instantanées,
- un capteur de position ou de temps (2) associé au convertisseur électromécanique (3) pour commander la lecture des données dans la mémoire de fonction selon la position ou le temps et
- un régulateur de puissance (6) pour appliquer des tensions ou intensités aux bornes électriques du convertisseur (3) selon les valeurs instantanées.

**16.** Montage selon la revendication 15, caractérisé en ce que l'unité arithmétique (20) comporte des éléments multiplicateurs (21, 22) pour combiner les jeux de données lus avec chaque fois une grandeur d'entrée (24, 25, 26, 27) ainsi qu'un élément d'addition/ soustraction (23) pour réunir avec ou sans exploitation, les résultats de la multiplication.

**17.** Montage selon la revendication 15 ou 16, pour un convertisseur (3) polyphasé,
caractérisé en ce que des jeux de données correspondants sont enregistrés pour les différentes phases et en liaison avec les grandeurs d'entrée (24, 25, 26, 27) on déduit des valeurs instantanées correspondantes et en ce que pour chacune des différentes phases on met en oeuvre des mémoires de fonction (30) correspondantes, des unités arithmétiques (20) et des régulateurs de puissance (6) ou on les fait travailler de manière multiplexée dans le temps.

**18.** Montage selon la revendication 15 ou 16 pour un convertisseur polyphasé (3),
caractérisé en ce que l'on enregistre des jeux de données communs pour toutes les phases et
- pour les différentes phases on lit ces jeux de données avec déphasage et on les combine dans la ou les unités arithmétiques (20) avec les grandeurs d'entrée (24, 25, 26, 27) pour former les valeurs instantanées associées aux différentes phases.

**19.** Montage selon la revendication 15 ou 16 pour un convertisseur polyphasé (3),
caractérisé en ce que l'on enregistre des jeux de données communs pour toutes les phases et à partir de ces jeux de données on déduit des valeurs instantanées et en ce qu'il est prévu une unité de déphasage qui, à partir des valeurs instantanées communes, déduit les valeurs instantanées déphasées de l'angle de phase correspondant pour toutes les phases.

Fig. 1

Fig. 2

Fig. 3

Fig. 4

Fig. 5

Beginn

↓

Definitionen: *
Phasenwiderstände $R_k$
max. zulässige Drehmomentschwankung $T_{zul}$

↓

Messung des Trägheitsmomentes J
durch einen Hochlaufversuch

↓

Messung des drehzahlabhängigen
Reibungsmomentes $T_2(\dot{\omega})$

↓

k = 0

↓

k = k + 1

↓

Messung der induzierten Phasenspannung $E_k(\delta)$
bei der Drehzahl $\omega_0$ *

↓

k = m ?

n

↓ j

Fig.6a

$$\xi = 0$$

Incrementierung des Iterationsindexes
$$\xi = \xi + 1$$

Antrieb des Prüfmotors durch einen
Servomotor [1]

Aufnahme von winkelabhängigen Messkurven
während einer Motorumdrehung
Messung des Ankerstromes des Servomotors,
Messung der Winkelgeschwindigkeit,
Messung der Winkelbeschleunigung;

Berechnung des winkelabhängigen Stillstandsmomentes $T_{r_\xi}(\delta)$ nach Gl. 3 –8

$T_{r_\xi}(\delta)|_{max} < T_{zul}$ ?

Ende

$$k = 0$$

Fig. 6 b

$$k = k + 1$$

Berechnung der Stromkurve $I_{k_\xi}(\delta)$

nach Gleichung ( 2 -9)
zur Kompensation von $T_{r_\xi}(\delta)$

$$I_{k_\xi}(\delta) = I_{k_\xi}(\delta) + I_{k_{\xi-1}}(\delta)$$

$k = m$ ?

n

j

Betrieb des Prüfmotors mit den neu
ermittelten Stromkurven $I_{k_\xi}(\delta)$

Fig. 6c

Fig. 7

Fig. 11a

Fig. 11b

Fig. 11c

EP 0 448 610 B1

Fig.8

Fig. 9

Fig. 10

EP 0 448 610 B1